# EUROPEAN PATENT APPLICATION

(11) **EP 1 995 777 A1**
(43) Date of publication of application: **26.11.2008**
(21) Application number: 08154902.4
(22) Date of filing: 21.04.2008
(51) Int. Cl.: H01L 23/492

(54) **Transistor package with wafer level dielectric isolation**

(30) Priority: 21.05.2007 US 804925
(71) Applicant: Delphi Technologies, Inc., Troy, Michigan 48007 (US)
(72) Inventor: Myers, Bruce A., Kokomo, IN 46901 (US); Peugh, Darrel E., Kokomo, IN 46901 (US); Elmoursi, Alaa A., Troy, MI 48098 (US); Van Steenkiste, Thomas H., Ray, MI 48096 (US); Zhao, Zhibo, Novi, MI 48377 (US); Gillespie, Bryan A., Macomb Township, MI 48044 (US)
(74) Representative: Denton, Michael John

(57) **Abstract**

A low cost transistor package (10) is provided for high power applications. The package provides high thermal conductivity and dissipation for a silicon transistor die (12), high current carrying capability and isolation, and high power and thermal cycle life performance and reliability. A dielectric layer (16) is fixed to a silicon transistor die (12), for coupling to a heat conducting buffer (26) and attachment to a substrate (24). The dielectric layer (16) is fixed to the die (12) by growing the dielectric layer (16), depositing the dielectric layer (16), or applying the dielectric layer (16) using a plasma spray. In an aspect, a conductive layer (14) is formed to the silicon transistor die (12) by a thermal or kinetic spray process, and the dielectric layer (16) is applied to the conductive layer (14). The dielectric layer (16) may also be established either before or after the transistor fabrication. Electrical and thermal interconnects are advantageously positioned from opposite sides of the silicon transistor die (12).

## Description

### TECHNICAL FIELD

The invention relates generally to power transistors, and more particularly to a transistor package having a thermally conductive dielectric layer fixed at the wafer level of a transistor chip, and associated electrical interconnects positioned on an opposite side of the transistor chip.

### BACKGROUND OF THE INVENTION

Current technical challenges in electronic packaging include the reduction of real estate and enhancing thermal performance. In high power electronic applications, utilizing several tens of Amperes, there are ongoing efforts to improve heat dissipation from the silicon device to the heat sink. This is typically accomplished by using high thermal conductivity materials and eliminating or reducing the use of low thermal conductivity layers between the silicon device and the heat sink. One of the layers required for mounting vertical power transistors such as Field Effect Transistors (FETs) and Insulated-Gate Bipolar Transistors (IGBTs) is the dielectric layer. It is essential that this layer maintain a specific stand off voltage, typically several hundred volts, between the backside of the chip (drain or collector electrical connection) and the heat sink, and it should also contribute the smallest possible thermal resistance.

For high power transistors, aluminum oxide, silicon carbide, aluminum nitride or beryllium oxide dielectric substrates are commonly used for this purpose. These substrates have a high thermal conductivity of 20 - 200 W/m-K but are high cost options and become even more costly when thick conductors such as direct bond copper are used for high current carrying capability. Beryllium oxide also has significant health related restrictions in some countries. These substrates are also are manufactured in thicknesses in the range of 1 to 0.5 mm. Although thinner plates as thin as 0.2 mm are also fabricated, they are higher in cost and are inadequately fragile.

In many applications, the silicon transistor chip is attached to the metallized substrate using solder, and the opposite side of the substrate is thermally connected to a heat sink using thermal grease. In other applications, the high-power silicon package is pressed against the dielectric layer using thermal grease having a thermal conductivity < 1 W/m-K. In both cases, the thermal grease adds to the thermal resistance between the silicon device and the heat sink, degrading thermal performance.

### SUMMARY OF THE INVENTION

A low cost transistor package is provided for high power and high current applications. The package provides high thermal conductivity and heat dissipation of the silicon transistor chip, high current carrying capability and isolation, and high power and thermal cycle life performance and reliability. The use of high cost substrates or thermal grease, as utilized in contemporary designs, is unneeded. Fabrication of metal layers and a dielectric layer at the transistor wafer level is accomplished using low cost materials. The package also employs a simplified assembly when compared to contemporary designs.

The dielectric layer may be established either before or after the transistor fabrication with preferential placement of the thermal and electrical interconnects. An electrical interconnect connects a top side of a silicon transistor die to a substrate, and the thermal interconnect is situated on a bottom side of the silicon transistor die adjacent to a heat conducting buffer. In an embodiment, the substrate is situated on both the top and the bottom side of the silicon transistor die. An overmold may also be utilized to encompass the transistor package with the electrical interconnect lead members extending therethrough.

Features of the invention are achieved in part by fixing a dielectric layer to a silicon transistor die with a conductive layer situated therebetween, for coupling to a heat conducting buffer and attachment to a substrate such as a printed circuit board. The dielectric layer may be fixed to the die either by growing the dielectric layer, depositing the dielectric layer, or applying the dielectric layer using a selection of sprays. The dielectric layer can be simultaneously deposited, grown or applied on numerous devices. The die surface may be metallized if necessary. In an embodiment, a connective layer (i.e., drain or collector) is formed on the substrate by selective positioning of the dielectric layer on the silicon transistor die. When the dielectric layer is grown or deposited, a patterning or an etching of a portion of the dielectric layer forms the connective layer. When the dielectric layer is applied using the spray, a mask is used to cover a portion of the silicon transistor die, preventing the spray from being applied to the silicon transistor die and forming the connective layer. The connective layer is electrically isolated by the positioning of the dielectric layer, and in an embodiment, the connective layer is formed along a periphery of the transistor die.

In an embodiment, the conductive layer (i.e., aluminum) is formed to the silicon transistor die by a thermal spray process or a kinetic spray process, and the dielectric layer is applied to the conductive layer. In an embodiment, the dielectric layer is either an aluminum oxide coating or a silicon nitride coating applied to the conductive layer using a plasma spray, thermal spray, or vapor deposition process. In an embodiment, the dielectric layer is fixed to an isolation die formed between the silicon transistor die and the dielectric layer, the isolation die being fixed to the silicon transistor die after fabrication of the silicon transistor die.

In an embodiment, an electrical interconnect (i.e., gate, base, source or emitter) connects a top side of the silicon transistor die to the substrate, and the dielectric layer (thermal interconnect) and connective layer (i.e., drain or emitter) are situated on a bottom side of the silicon transistor die. This positioning allows electrical and thermal interconnects to be advantageously made from opposite sides of the silicon transistor die.

Other features and advantages of this invention will be apparent to a person of skill in the art who studies the invention disclosure. Therefore, the scope of the invention will be better understood by reference to an example of an embodiment, given with respect to the following figures.

### BRIEF DESCRIPTION OF THE DRAWINGS

The foregoing aspects and many of the attendant advantages of this invention will become more readily appreciated by reference to the following detailed description, when taken in conjunction with the accompanying drawings, wherein:
FIG. 1 is a sectional side view of a silicon transistor die having a dielectric layer fixed thereto coupled to a heat conducting buffer and attached to a substrate, in accordance with an embodiment of the present invention;
FIG. 2 is a sectional side view of a silicon transistor die having a dielectric layer fixed thereto on a bottom side coupled to a heat conducting buffer, the substrate situated both above and below the die, in accordance with an embodiment of the present invention;
FIG. 3 is a sectional side view as in FIG. 1, wherein the dielectric layer is alternatively applied by spray process to an isolation die formed between the silicon transistor die and the dielectric layer, in accordance with an embodiment of the present invention;
FIG. 4 is a bottom view of the transistor package showing the positioning of the transistor die, the dielectric layer, and conductive layer, in accordance with an embodiment of the present invention;
FIG. 5 is a top view of the transistor package showing the positioning of the transistor die, and the electrical interconnects including the source/emitter and gate/base, in accordance with an embodiment of the present invention;
FIG. 6 is a bottom view of the transistor package showing the positioning of the conductive layer (drain/collector), the transistor die, the dielectric layer, and the heat conducting buffer, in accordance with an embodiment of the present invention;
FIG. 7 is a sectional side view of a silicon transistor die having a dielectric layer fixed thereto coupled to a heat conducting buffer and attached to a substrate, and further illustrating electrical interconnects, wire bonds and through hole pins, in accordance with an embodiment of the present invention;
FIG. 8 is a top view of the transistor package as in FIG. 7 showing the positioning of the electrical interconnects and respective wire bonds, the conductive layer, and the respective interconnect pins, in accordance with an embodiment of the present invention;
FIGs. 9A-9E are sectional side views of alternative electrical interconnects that connect a top substrate to a bottom substrate, illustrating an interposer, a pin fixed to the top substrate, an edge clip, a combination pin and edge clip, and a lead frame formed to make a pin, in accordance with embodiments of the present invention;
FIGs. 10A-10D are sectional side views of alternative electrical interconnects that pass through a through hole defined within a conductive core contained by the substrate, the interconnects including a non-continuous conductive core, a conductive core detached at the through hole, a conductive core detached around the through hole, and an isolator positioned between the through hole and the conductive core, in accordance with embodiments of the present invention; and
FIG. 11 is a sectional side view of a transistor package further including an overmold to encompass the transistor package with the electrical interconnect lead members extending therethrough, in accordance with embodiments of the present invention.

### DESCRIPTION OF THE PREFERRED EMBODIMENT

Exemplary embodiments are described with reference to specific configurations. Those of ordinary skill in the art will appreciate that various changes and modifications can be made while remaining within the scope of the appended claims. Additionally, well-known elements, devices, components, methods, process steps and the like may not be set forth in detail in order to avoid obscuring the invention. Further, unless indicated to the contrary, the numerical values set forth in the following specification and claims are approximations that may vary depending upon the desired characteristics sought to be obtained by the present invention.

A system and method is described herein for providing a low cost transistor package for high power and high current applications. The package provides high thermal conductivity and heat dissipation of a silicon transistor chip, high current carrying capability and isolation, and high power and thermal cycle life performance and reliability. Fabrication of metal layers and a dielectric layer at the transistor wafer level is accomplished using low cost materials. The package also employs a simplified assembly when compared to contemporary designs. The dielectric layer may be established either before or after the transistor fabrication with preferential placement of the thermal and electrical interconnects.

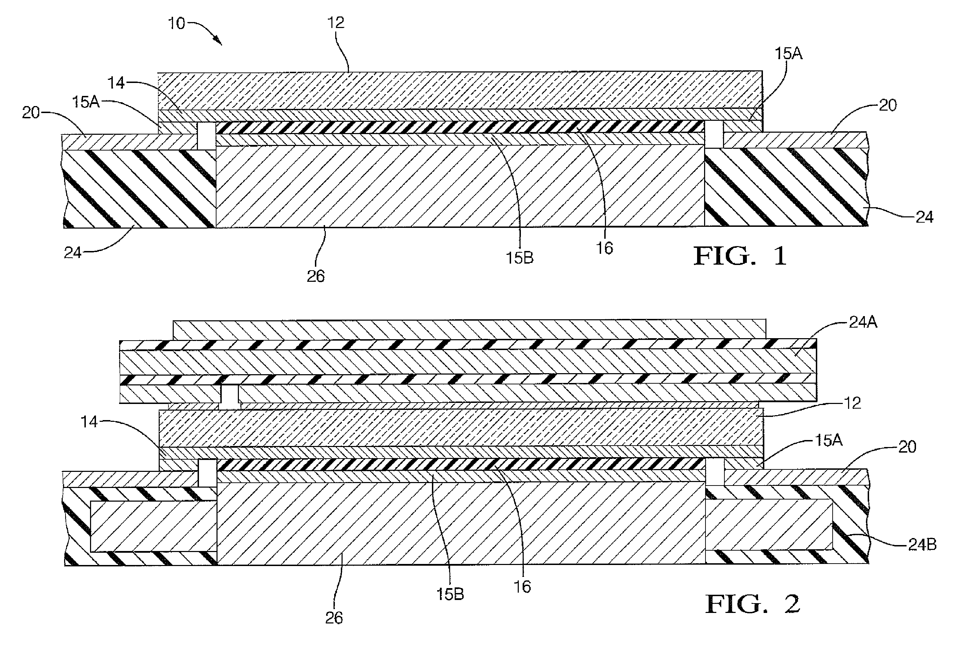

Referring to the drawings wherein identical reference numerals denote the same elements throughout the various views, **FIG. 1** illustrates a sectional side view of a transistor package 10, in accordance with an embodiment of the present invention. The transistor package 10 includes a dielectric layer 16 fixed to a silicon transistor die 12, with a conductive layer 14 situated therebetween, for coupling to a heat conducting buffer 26 and attachment to a substrate 24, such as a printed circuit board. The dielectric layer 16 may be fixed to the die 12 either by growing the dielectric layer 16, depositing the dielectric layer 16, or applying the dielectric layer 16 using a selection of sprays. The dielectric layer 16 can be simultaneously deposited, grown or applied on numerous devices.

A conductive layer 20 (i.e., drain or collector) is formed on the substrate 24 by using standard printed circuit or ceramic fabrication techniques. Conductive layer 14 is formed during wafer processing by either sputtering or vapor deposition. A connective layer 15A is formed on the die at the wafer level by selective positioning of the dielectric layer 16 on the silicon transistor die 12. That is, when the dielectric layer 16 is grown or deposited, a patterning or an etching of a portion of the dielectric layer 16 exposes a portion of the connective layer 15A on the die 12. When the dielectric layer 16 is applied using the spray, a mask is used to cover a portion of the silicon transistor die 12, preventing the spray from being applied to the silicon transistor die 12 and forming the exposed portion of the connective layer 15A. The connective layer 15A is electrically isolated by the positioning of the dielectric layer 16, and in an embodiment, the connective layer 15A is formed along a periphery of the transistor die 12. The connective layer 15A and connective layer 15B can be made of either a conductive adhesive or a cap metal with solder. Solder or adhesive may further be used to attach connective layer 15A to the conductive layer 20, and to attach dielectric layer 16 to heat conducting buffer 26. The heat conducting buffer 26 is electrically isolated from the conductive layer 14 by way of the dielectric layer 16 and the selective patterning of the connective layer 15A. Space 17 is defined to electrically disconnect the transistor chip 12 to conductive layer 20 connection from the transistor chip 12 to buffer 26 connection. That is, space 17 electrically disconnects conductive layer 20 from buffer 26. Space 17 is defined by selected positioning of connective layer 15A.

In an embodiment, connective layer 15A is utilized to connect the conductive layer 14 to conductive layer 20 and to substrate 24. In an alternative embodiment, a connective layer 15B is formed to the dielectric layer 16 for connecting the dielectric layer 16 to the heat conducting buffer 26. In a further embodiment, both the connective layer 15A and the connective layer 15B are utilized, wherein connective layer 15A connects the conductive layer 14 to the conductive layer 20, and connective layer 15B connects the dielectric layer 16 to the heat conducting buffer 26.

The heat conducting buffer 26 (i.e., a copper, Molybdenum, or other metal insert) is part of the substrate 24, and connected with an outside package heat sink (not shown). The connective layer 15A is grown or deposited on the transistor die 12 at the wafer level and the pattern is formed using either masking or etching techniques as described above. The connective layer 15B is typically a metal or layers of metals to provide adhesion to the dielectric layer 16 and to provide a suitable surface to attach layer 15B (i.e., copper, nickel, gold, etc.) to the conducting buffer 26 with either solder or a thermally conductive adhesive. When these processes are complete the individual transistor die 12 is cut from the transistor wafer for assembly onto the substrate 24.

The surface of the transistor die 12 may be metallized (i.e., aluminum) if necessary. In an embodiment, conductive layer 14 is formed by a thermal spray process or a kinetic spray process, and the dielectric layer 16 is applied to the conductive layer 14. In an embodiment, the dielectric layer 16 is either an aluminum oxide (Al₂O₃) coating or a silicon nitride (Si₃N₄) coating applied to the conductive layer 14 using a plasma spray. Here, the dielectric layer 16 may be applied after the transistor die 12 fabrication. In an alternative embodiment, the dielectric layer 16 is a composite coating conductive layer of plasma sprayed alumina and copper. These processes are performed at the wafer level prior to the singulation of the die from the wafer.

**FIG. 2** is a sectional side view of a silicon transistor die 12 having a top substrate 24A situated above the silicon transistor die 12 and bottom substrate 24B situated below the silicon transistor die 12, in accordance with an embodiment of the present invention. The dielectric layer 16 is affixed at the bottom side of the silicon transistor die 12. A dielectric layer may also be affixed to the top side of the silicon transistor die 12 providing two-sided thermal conductivity and heat dissipation (not shown).

The following represent experimental result examples provided for illustrative purposes and are not intended to be limiting, as modifications and variations may be made. Thermal resistance calculations for a transistor package were completed, given a 7 by 7 mm die, a 5 by 5 mm pedestal and grease. For a transistor package having one substrate (as in FIG. 1) and a dielectric layer of alpha alumina at 10 mils was used, 0.52 C/W was recorded. When a dielectric layer of SiN at 4 mils thick was used, 0.37 C/W was recorded. For a transistor package having two substrates (as in FIG. 2) and a dielectric layer of alpha alumina at 10 mils thick was used, 0.37 C/W was recorded. When a dielectric layer of SiN at 4 mils thick was used, 0.29 C/W was recorded.

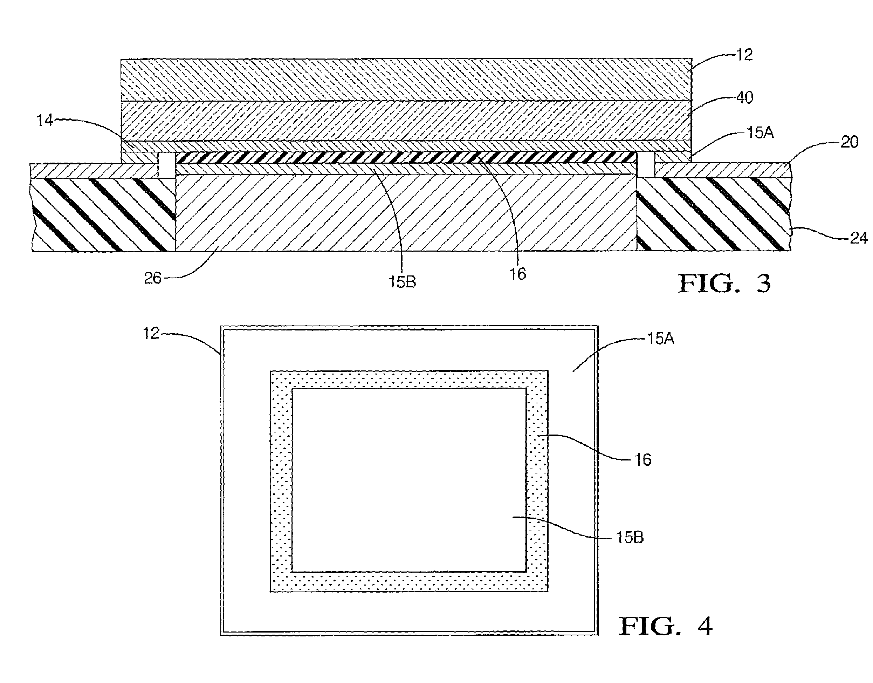

Referring to **FIG. 3****,** a sectional side view of a transistor package as in FIG. 1 is illustrated. The dielectric layer 16 is fixed to an isolation die 40 situated between the silicon transistor die 12 and the dielectric layer 16, in accordance with an alternative embodiment of the invention. That is, the dielectric layer 12 is fixed to the isolation die 40 rather than to the transistor die 12. The isolation die 40 may then be fixed to the silicon transistor die 12 after fabrication of the silicon transistor die 12. The isolation die 40 is bonded to the transistor die 12 after both dies have completed their respective processes. These processes are performed at the wafer level prior to the singulation of the die from the wafer.

**FIG. 4** shows a bottom view of a singulated transistor die 12 as in FIG. 1, illustrating the positioning of the connective layer 15A, the dielectric layer 16, and the connective layer 15B, in accordance with an embodiment of the present invention. Here, the connective layer 15A is selectively patterned along the periphery of the transistor die 12. It is to be appreciated that in an alternative embodiment, as in FIG. 3, the isolation die 40 would be illustrated rather than the transistor die 12.

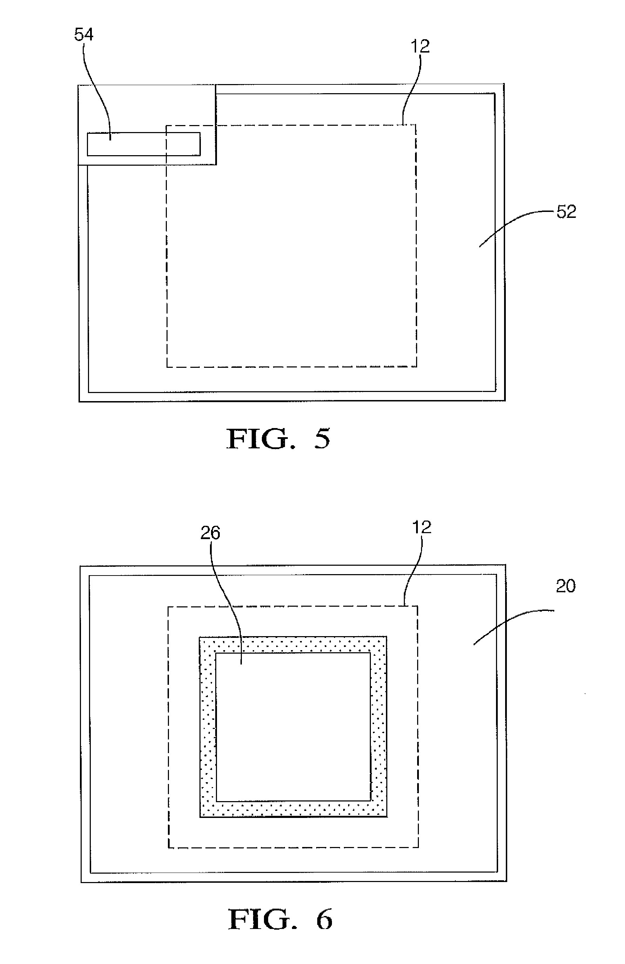

**FIG. 5** is a top view of a transistor package showing the positioning of the transistor die 12, and the electrical interconnects including the source or emitter 52 and gate or base 54, in accordance with an embodiment of the present invention. These designated areas of the electrical interconnects may be varied based upon the transistor die requirements. **FIG. 6** is a bottom view is of a transistor package illustrating the positioning of the conductive layer 20 (drain/collector), and the positioning of the transistor die 12 and the heat conducting buffer 26, in accordance with an embodiment of the present invention.

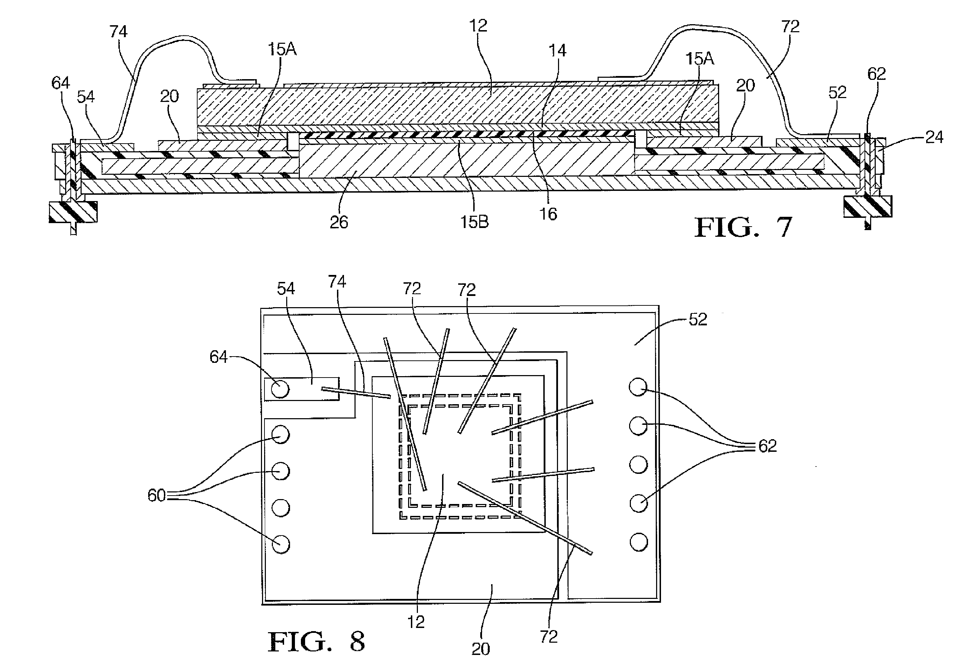

Referring to **FIG. 7**, a sectional side view of a silicon transistor die 12 is illustrated having a dielectric layer 16 fixed thereto coupled to a heat conducting buffer 26 through metal layer 15B and a solder joint and attached to a substrate 24, in accordance with an embodiment of the present invention. Electrical conductors 52 (i.e., source or emitter) and 54 (i.e., gate or base) connect to the wire bonds 72 and 74 (connected from the top side of the silicon transistor die) to the substrate 24. The dielectric layer 16 (a thermal interconnect) is situated on a bottom side of the silicon transistor die 12 adjacent to the heat conducting buffer 26. In an embodiment, this positioning allows the electrical interconnects and thermal interconnects to be situated on opposite sides of the silicon transistor wafer. Additionally, wire bonds 72 and 74 interconnect the transistor die 12 to the electrical conductors 52 and 54. Besides wire bonds, other connectors may be utilized including bar bonds. Through hole pins 62 and 64 are positioned through the substrate 24 providing a final transistor package interconnect.

**FIG. 8** shows a top view of the transistor package as in FIG. 7 showing the positioning of the electrical conductors 52 and 54 and respective wire bonds 72 and 74, the conductive layer 20, and the respective interconnect pins 60, 62 and 64. A connection point of the wire bonds 72 and 74, and thermal interconnects (not shown in FIG. 8) are situated on opposite sides of the silicon transistor die.

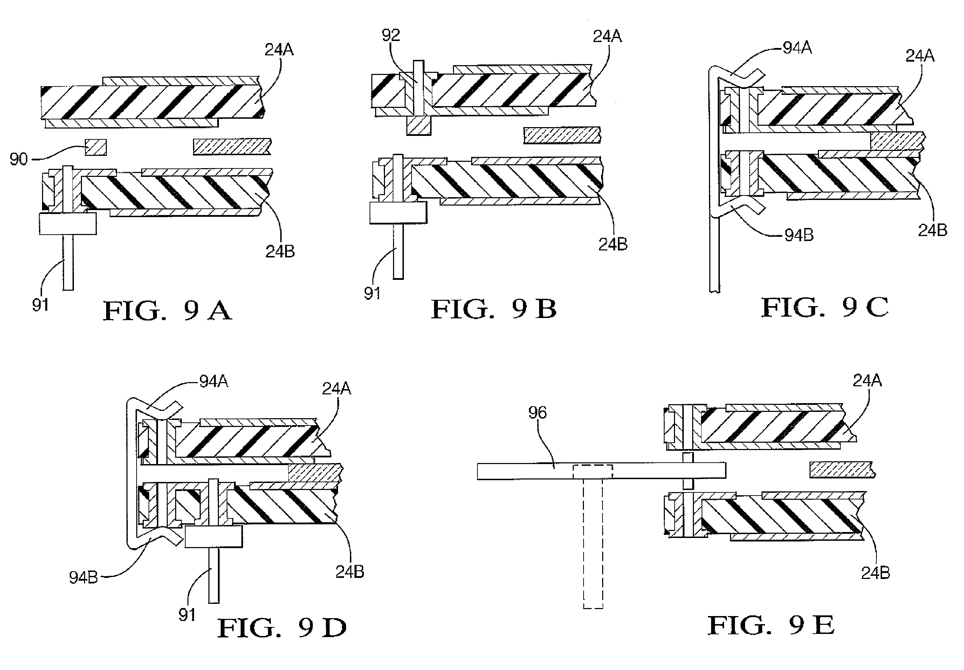

**FIG. 9A - 9E** are sectional side views of alternative electrical interconnects that connect a top substrate 24A to a bottom substrate 24B, wherein the dielectric layer 16 is fixed as described above. The illustrated alternative electrical interconnects may be employed with the present invention, although it will be appreciated that other interconnect designs may be employed. The illustrated electrical interconnects provide an electrical connection from the gate or base, and source or collector, to the bottom substrate 24B.

In **FIG. 9A**, a conductive interposer 90 is illustrated situated between the top substrate 24A and the bottom substrate 24B. The interposer 90 provides an electrical connection from the gate or base, and source or collector, to a pin 91 that is fitted into and extends from the bottom substrate 24B. In **FIG. 9B**, a conductive pin 92 fitted into the top substrate 24A unites with a conductive pin 91 fitted into, and extending from, the bottom substrate 24B. In **FIG. 9C**, an edge clip 94A fixed to the top substrate 24A unites with an edge clip 94B fixed to the bottom substrate 24B. In **FIG. 9D**, a combination pin and edge clip is employed. Edge clip 94A is fixed to the top substrate 24A and unites with edge clip 94B fixed to the bottom substrate 24B. Further, edge clip 94B is connected with pin 91 that is fitted into, and extends from, the bottom substrate 24B. In **FIG. 9E**, a lead frame 96 formed to make a pin is employed. The lead frame 96 extends from the top substrate 24A to the bottom substrate 24B. The pin extends out of the transistor package from an intermediate point between the top substrate 24A and the bottom substrate 24B.

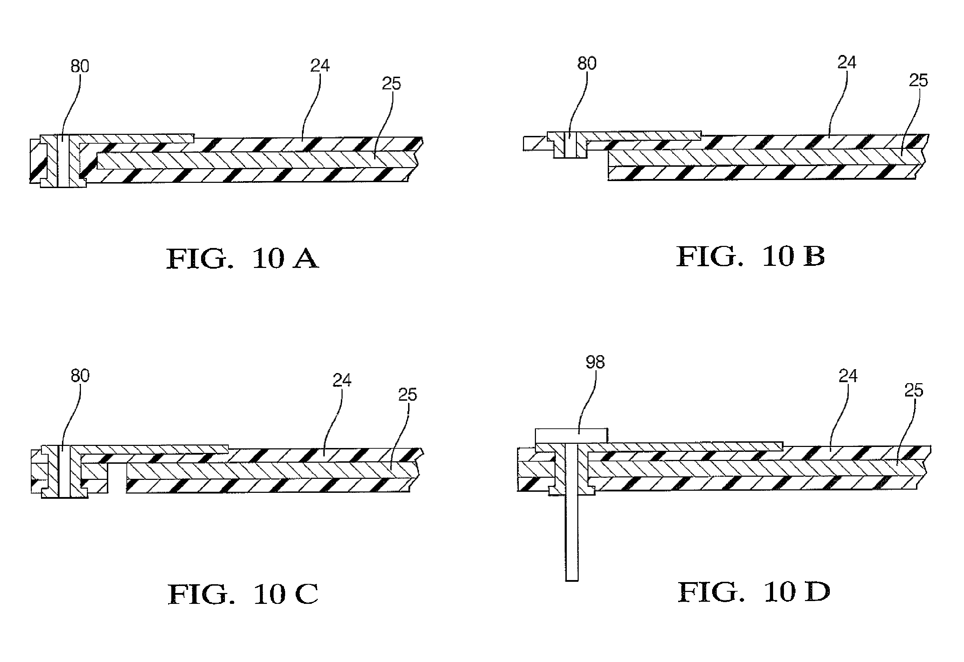

**FIGs. 10A-10D** are sectional side views of alternative electrical interconnects that pass through a through hole 80 defined within a conductive core 25 contained by the substrate 24. The alternative interconnects that can be employed with the present invention include a conductive core 25 that is non-continuous at a through hole 80 (FIG. 10A), a conductive core 25 detached at the through hole 80 (FIG. 10B), a conductive core 25 detached about the through hole 80 (FIG. 10C), and an electrically insulated isolator 98 positioned between the through hole 80 and the conductive core 25 (FIG. 10D). The illustrated electrical interconnects are consequently electrically isolated from the conductive core 25. As such, the conductive layer 20 (i.e., drain or collector) is electrically isolated from the electrical conductor 52 (i.e., source or emitter) and electrical conductor 54 (i.e., gate or base).

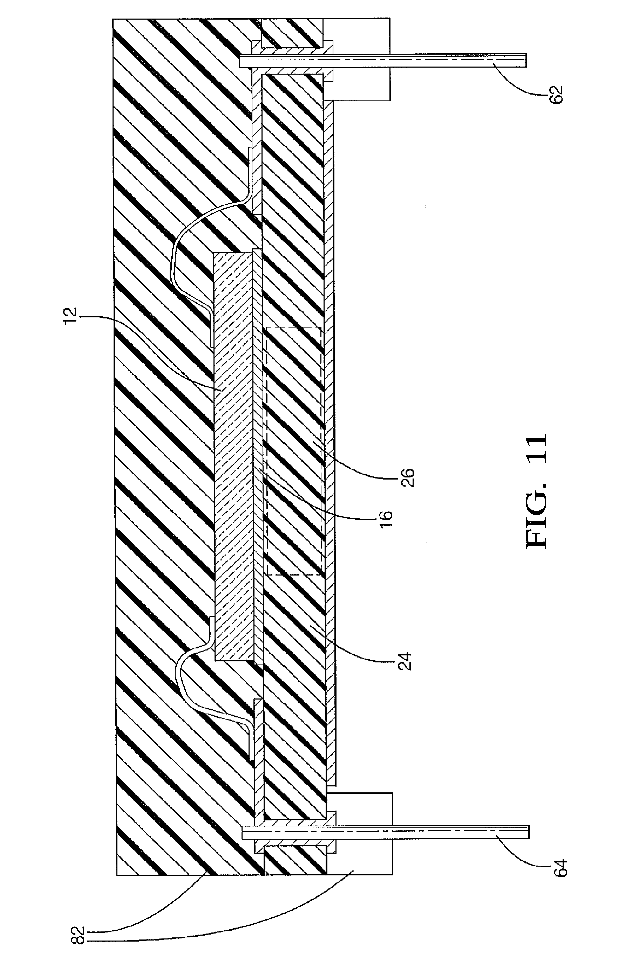

**FIG. 11** is a sectional side view of a transistor package including an overmold 82 used to encompass the transistor package having the dielectric layer 16 fixed to the die 12 with electrical interconnect lead members 62 and 64 extending through substrate 24. The overmold 82 may be employed with alternative embodiments as described above. Further, overmold 82 may be employed when lead frames, rather than substrates, are utilized with the electrical interconnects.

Other features and advantages of this invention will be apparent to a person of skill in the art who studies this disclosure. Thus, exemplary embodiments, modifications and variations may be made to the disclosed embodiments while remaining within the spirit and scope of the invention as defined by the appended claims.

## Claims

1. A transistor package (10) comprising:
a silicon transistor die (12) for attachment to a substrate (24);
a dielectric layer (16) fixed to the silicon transistor die (12) with a conductive layer (14) situated therebetween, the dielectric layer (16) for coupling to a heat conducting buffer (26), the heat conducting buffer (26) attached to the substrate (24); and
a connective layer (15) formed to:
the dielectric layer (16) for connecting the dielectric layer (16) to the heat conducting buffer (26), or
the conductive layer (14) for connecting the conductive layer (14) to the substrate (24), or
the dielectric layer (16) for connecting the dielectric layer (16) to the heat conducting buffer (26), and the conductive layer (14) for connecting the conductive layer (14) to the substrate (24).

2. The transistor package (10) as in claim 1, wherein the dielectric layer (16) is fixed to the silicon transistor die (12) by growing the dielectric layer (16), depositing the dielectric layer (16), or applying the dielectric layer (16) using a spray, wherein when the dielectric layer (16) is grown or deposited, a patterning or an etching of a portion of the dielectric layer (16) forms the connective layer (15A), and wherein when the dielectric layer (16) is applied using the spray, a mask is used to cover a portion of the silicon transistor die (12), preventing the spray from being applied to the silicon transistor die (12) and forming the connective layer (15A).

3. The transistor package (10) as in claim 1, wherein the conductive layer (14) is formed to the silicon transistor die (12) by a thermal spray process or a kinetic spray process, and wherein the dielectric layer (16) is applied to the conductive layer (14).

4. The transistor package (10) as in claim 3, wherein the conductive layer (16) is aluminum formed to the silicon transistor die (12) using the kinetic spray.

5. The transistor package (10) as in claim 3, wherein the dielectric layer (16) is an aluminum oxide coating applied to the conductive layer (14) using a plasma spray.

6. The transistor package (10) as in claim 3, wherein the dielectric layer (16) is a silicon nitride coating applied to the conductive layer (14) using a plasma spray.

7. The transistor package (10) as in claim 1, wherein the dielectric layer (16) comprises a composite coating conductive layer of plasma sprayed alumina and copper.

8. The transistor package (10) as in claim 1, further comprising an electrical interconnect (72, 74) connecting a top side of the silicon transistor die (12) to the substrate (24), with the dielectric layer (16) on a bottom side of the silicon transistor die (12) adjacent to the heat conducting buffer (26).

9. The transistor package (10) as in claim 8, wherein the electrical interconnects (72, 74) include a gate, base, source and emitter, and wherein the connective layer (20) between the conductive layer (14) and the substrate (24) is fixed to a drain or a collector.

10. The transistor package (10) as in claim 8, wherein:
the substrate (24) comprises a top substrate (24A) and a bottom substrate (24B);
the electrical interconnect connects the top substrate (24A) to the bottom substrate (24B), utilizing one of an interposer (90), a pin (92) fixed to the top substrate (24A), an edge clip (94), a combination pin (91) and edge clip (94), and a lead frame (96) formed to make a pin; and
the electrical interconnect passes through a through hole (80) defined within a conductive core (25) contained by the substrate (24), the electrical interconnect being electrically isolated from the conductive core (25) utilizing one of a non-continuous conductive core, a conductive core detached at the through hole (80), a conductive core detached around the through hole (80), and an isolator (98) positioned between the through hole (80) and the conductive core (25).

11. The transistor package (10) as in claim 1, further comprising an isolation die (40) situated between the silicon transistor die (12) and the dielectric layer (16), wherein the isolation die (40) is fixed to the silicon transistor die (12) after fabrication of the silicon transistor die (12).

12. The transistor package (10) as in claim 1, further comprising an overmold (82) encompassing the transistor package (10), wherein an electrical interconnect (62, 64) extends therethrough.

13. A method of fabricating a transistor package (10) comprising:
affixing a dielectric layer (16) to a silicon transistor die (12) with a conductive layer (14) situated therebetween, the dielectric layer (16) for coupling to a heat conducting buffer (26), the heat conducting buffer (26) attached to a substrate (24); and
forming a connective layer (15) to:
the dielectric layer (16) for connecting the dielectric layer (16) to the heat conducting buffer (26), or
the conductive layer (14) for connecting the conductive layer (14) to the substrate (24), or
the dielectric layer (16) for connecting the dielectric layer (16) to the heat conducting buffer (26), and the conductive layer (14) for connecting the conductive layer (14) to the substrate (24).

14. The method as in claim 13, further comprising affixing the dielectric layer (16) to the silicon transistor die (12) by growing the dielectric layer (16), depositing the dielectric layer (16), or applying the dielectric layer (16) using a spray, wherein when the dielectric layer (16) is grown or deposited, a portion of the dielectric layer (16) is patterned or an etched to form the connective layer, and wherein when the dielectric layer (16) is applied using the spray, a mask is used to cover a portion of the silicon transistor die (12), preventing the spray from being applied to the silicon transistor die (12) and forming the connective layer (15A).

15. The method as in claim 13, wherein the conductive layer (14) is formed to the silicon transistor die (12) utilizing a thermal spray process or a kinetic spray process, and wherein the dielectric layer (16) is applied to the conductive layer (14).

16. The method as in claim 15, wherein the conductive layer (14) is formed of aluminum using the kinetic spray process.

17. The method as in claim 15, wherein the dielectric layer (16) is applied to the conductive layer (14) using a plasma spray, the dielectric layer (16) being an aluminum oxide coating or a silicon nitride coating.

18. The method as in claim 13, further comprising connecting an electrical interconnect (72, 74) from a top side of the silicon transistor die (12) to the substrate (24), with the dielectric layer (16) on a bottom side of the silicon transistor die (12) adjacent to the heat conducting buffer (26), wherein the electrical interconnects (72, 74) include a gate, base, source or emitter, and wherein the connective layer (20) is fixed to a drain or a collector.

19. The method as in claim 13, further comprising situating an isolation die (40) between the silicon transistor die (12) and the dielectric layer (16), and fixing the isolation die (40) to the silicon transistor die (12) after fabrication of the silicon transistor die (12).

20. The method as in claim 13, further comprising forming an overmold (82) to encompass the transistor package (10), and extending an electrical interconnect (62, 64)) therethrough.
